# FASCICULE DE BREVET EUROPEEN

(11) **EP 2 616 574 B1**
(45) Date de publication et mention de la délivrance du brevet: **24.02.2016**
(21) Numéro de dépôt: 11773094.5
(22) Date de dépôt: 15.09.2011
(51) Int. Cl.: C30B 7/00, C30B 29/54, C30B 29/58, C30B 7/08

(54) **DISPOSITIF ET PROCÉDÉ DE CRISTALLISATION DE SUBSTANCES INORGANIQUES OU ORGANIQUES**
VORRICHTUNG UND VERFAHREN ZUR KRISTALLISIERUNG VON ANORGANISCHEN ODER ORGANISCHEN STOFFEN
DEVICE AND METHOD FOR CRYSTALLISING INORGANIC OR ORGANIC SUBSTANCES

(30) Priorité: 15.09.2010 FR 1057354
(43) Date de publication de la demande: 24.07.2013
(73) Titulaire: Universite Joseph Fourier (Grenoble 1), 38041 Grenoble (FR)
(72) Inventeur: SPANO, Monika, F-38850 Charavines (FR)
(74) Mandataire: Chevalier, Renaud Philippe
(86) Numéro de dépôt international: PCT/FR2011/052121
(87) Numéro de publication internationale: WO 2012/035268

(56) Documents cités:
- WO-A1-2004/029338
- WO-A1-2006/099890
- US-A1- 2003 233 978
- US-B1- 6 596 081
- DUCRUIX ET AL.: "Solubility diagram analysis and the relative effectiveness of different ions on protein crystal growth", METHODS, vol. 1, no. 1, 1 août 1990 (1990-08-01), pages 25-30, XP002616092, cité dans la demande
- CHRISTOPHER G K ET AL: "Temperature-dependent solubility of selected proteins", JOURNAL OF CRYSTAL GROWTH, ELSEVIER, AMSTERDAM, NL, vol. 191, no. 4, 1 August 1998 (1998-08-01), pages 820-826, XP004151125, ISSN: 0022-0248, DOI: 10.1016/S0022-0248(98)00355-8

## Description

La présente invention concerne le domaine de la cristallisation de substances inorganiques ou organiques, et en particulier la cristallisation de molécules, notamment de macromolécules, telles que des protéines.

La compréhension des propriétés physico-chimiques de macromolécules telles que les protéines s'appuie généralement sur la connaissance de la structure atomique de ces macromolécules.

Afin d'étudier cette structure, on a essentiellement recours à des techniques de diffraction aux rayons X et de cristallographie neutronique.

La diffraction aux rayons X permet ainsi d'obtenir la structure tridimensionnelle des molécules à étudier, celle aux neutrons apporte des informations complémentaires sur les états de protonation des protéines et de leurs ligands, sur les positions et les orientations des molécules de l'eau et sur les réseaux de liaisons hydrogène.

En effet, pour la compréhension des processus biologiques, il est important de connaître précisément le positionnement des atomes d'hydrogène, comment ils sont transférés entre les molécules de protéine, les molécules du solvant et les substrats.

Ces techniques de diffraction nécessitent que les macromolécules à étudier se trouvent sous la forme cristalline, et plus avantageusement sous la forme de monocristaux de bonne qualité et de volume suffisant.

Dans le cadre de la présente invention, on entend par monocristal de bonne qualité, un monocristal présentant :
- une faible mosaïcité,
- un pouvoir de diffraction important (à savoir inférieur à 2 angström),
- un volume important, à savoir compris entre 0,001 mm³ pour la diffraction aux rayons X, et 1 mm³ pour la diffraction aux neutrons.

On entend aussi dans le cadre de la présente invention par macromolécules, des molécules ayant un poids moléculaire de plusieurs milliers de Daltons à plusieurs centaines de milliers de Daltons. Il peut s'agir de séquences d'acides nucléiques d'ADN ou d'ARN, de fragments de virus, de protéines, de complexes de protéines, de complexes protéine-ARN, de complexes protéine-ligand, ou encore de polypeptides.

De plus, la présente invention peut être appliquée avec succès à la cristallisation de plus petites molécules telles que des sucres, des antibiotiques, ou encore d'autres composés d'intérêt pharmaceutique.

Pour obtenir des monocristaux de bonne qualité et de volume important, il est essentiel de contrôler la cristallisation des macromolécules (à savoir la cristallogenèse), car c'est la cristallogenèse qui va gouverner les propriétés physico-chimiques du cristal ainsi obtenu.

La cristallogenèse se décompose en deux étapes :
- une première étape, dite de nucléation, consistant en l'apparition de germes cristallins à partir d'une solution de cristallisation.
- une deuxième étape, dite de croissance, consistant en la croissance cristalline des germes de cristaux obtenus lors de la nucléation.

La nucléation peut être perturbée par l'apparition :
- d'une phase solide ou liquide indésirable, par exemple un précipité amorphe ou une démixtion (une séparation liquide-liquide), ou
- d'une phase cristalline/polymorphe indésirable.

Le polymorphisme est la capacité d'une molécule à exister sous plusieurs formes cristallines. Or, dans le domaine pharmaceutique, l'approbation de normalisation d'un médicament est souvent soumise à l'exigence d'une seule forme cristalline ou d'un seul polymorphe d'une molécule donnée.

La croissance peut aboutir à la formation de cristaux de faible diffraction, voire même à la formation de polycristaux, ce qui entrave sérieusement la résolution de la structure tridimensionnelle des macromolécules.

Afin d'éviter ces problèmes précités, de longues et onéreuses recherches permettent d'obtenir des conditions optimales de la cristallisation des macromolécules.

Pour ce faire, il est essentiel de connaître :
- le comportement des molécules en solution avant la nucléation, à savoir la nature de leurs interactions (attractives/répulsives), les associations moléculaires : les paramètres de taille et de masse des particules formées en solution (monomère, dimère,...), la polydispersité (c'est-à-dire la présence d'une ou de plusieurs populations de particules formées en solution) ;
- le comportement des germes cristallins une fois formés et présents dans une solution de molécule à cristalliser, et cela en fonction des différents paramètres que sont :
   a) la température,
   b) la concentration de la molécule à cristalliser,
   c) la concentration des agents de cristallisation et/ou des additifs et
leur nature.

Dans le cadre de la présente invention, on entend par agent de cristallisation, des agents qui favorisent la cristallisation de la molécule à cristalliser. Il peut s'agir de :
- sels, tels que le sulfate d'ammonium, le chlorure de sodium, le phosphate de potassium;
- composés organiques, tels que l'isopropanol et le 2-methyl-2,4-pentanediol (MPD) ;
- des polyéthylène glycol, tels que le PEG 4000, le PEG 6000, ou encore le PEG 8000.

Dans le cadre de la présente invention, on entend par additif, des constituants permettant d'augmenter la stabilité de la molécule à cristalliser et/ou l'homogénéité de sa conformation. Il peut s'agir de détergents, d'agents réducteurs, de substrats, et de cofacteurs tels que les n-alkyl-β-glucosides ou n-alkyl-maltosides, le dithiotreitol (DTT), des lipides, des sous-unités ou des groupes prosthétiques.

Dans le cadre de la présente invention, on entend par tampon, un constituant permettant de maintenir à un pH fixe une solution dans laquelle il a été ajouté. Il peut s'agir du 2-(N-morpholino) Ethane Sulfonique Acide (ci-après abrégé « MES »), du 2-amino-2-hydroxyméthyl-1,3-propanediol (ci-après abrégé « Tris »), du 2-(Bis(2-hydroxyethyl)amino)acetique acide (abrégé « Bicine »), de l'acide 4-(2-hydroxyéthyl)-1-pipérazine éthane sulfonique (abrégé « Hepes ») ou du citrate de sodium, de l'acétate de sodium ou encore du cacodylate de sodium.

Il est souvent nécessaire de réaliser un diagramme de phases de la molécule à cristalliser qui est établi en fonction de ces trois paramètres a) à c) précités.

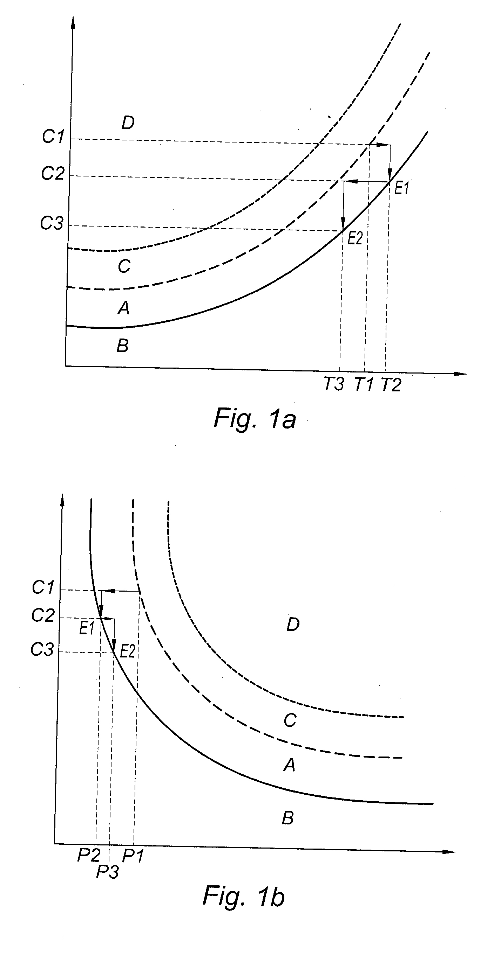

Un exemple de diagramme de phases est représenté sur la figure 1 a pour le cas d'une molécule à cristalliser ayant une solubilité directe.

Par molécule à cristalliser ayant une solubilité directe, on entend que la solubilité de la molécule à cristalliser augmente avec l'accroissement de la température.

Sur l'axe de l'abscisse de ce diagramme figure la température (exprimée en °C) et sur l'axe de l'ordonnée figure la concentration de la molécule à cristalliser présente en solution (exprimée en mg/mL).

On distingue sur ce diagramme quatre zones A à D qui sont établies et déterminées par une observation (par exemple au moyen d'un microscope optique) en temps réel de l'évolution du contenu de la solution de la molécule à cristalliser, dans laquelle ont été disposés des germes de cristaux de la molécule à cristalliser :
- Zone A : La zone métastable, dans laquelle la solution est faiblement sursaturée, et peut se maintenir ainsi très longtemps sans formation de cristaux, mais les cristaux ensemencés y grossissent ;
- Zone B : La nucléation n'a pas lieu et les cristaux ensemencés sont dissous : il s'agit de la zone dite « zone de sous-saturation »;
- Zone C : L'excès de la molécule à cristalliser se sépare de la solution de la molécule à cristalliser sous la forme de germes de cristaux (ou autrement dit de nucléis). Les cristaux ensemencés y grossissent : il s'agit d'une zone dans laquelle la nucléation est spontanée.
- Zone D : Les structures formées sont désordonnées. Il s'agit d'agrégats et/ou de précipités. Cette zone est dite « zone de précipitation», dans laquelle la sursaturation est tellement importante que la formation des agrégats et des précipités y est favorisée avant la formation des cristaux.

Les zones A, C et D forment ensemble la zone dite « zone de sursaturation ».

La zone métastable est limitée par deux courbes de natures différentes.

La frontière inférieure (à savoir la frontière entre la zone A et la zone B) est la courbe de solubilité, correspondant aux points d'équilibre thermodynamique entre la solution de la molécule à cristalliser et les cristaux. L'emplacement de cette courbe de solubilité sur le diagramme de phases est fixe et il est de nature thermodynamique. Une solution à cristalliser se situant sur cette courbe de solubilité demeure stable. Sur cette courbe de solubilité, la probabilité pour qu'un événement de nucléation se produise est nulle et le temps d'induction pour la nucléation est infini.

La limite supérieure de la zone métastable (à savoir la frontière entre la zone A et la zone C) est aussi dénommée « limite de métastabilité » ou « courbe de supersolubilité ».

A la différence de la courbe de solubilité, son emplacement sur le diagramme de phases est de nature cinétique. Il dépend du taux de progression de la sursaturation.

Sur cette courbe de supersolubilité, la probabilité pour qu'un événement de nucléation se produise est de 1, et le temps d'induction pour la nucléation est nul car la nucléation est instantanée.

Le temps d'induction de la nucléation étant fonction de la sursaturation, toute solution à cristalliser se situant dans la zone métastable du diagramme de phases peut nucléer spontanément. Plus haute est la sursaturation, plus court est le temps d'induction de la nucléation.

Un autre diagramme de phases de la molécule à cristalliser peut être établi en fonction de la concentration de la molécule à cristalliser (axe de l'ordonnée) et de la concentration en agent de cristallisation et/ou additif (axe de l'abscisse). Un tel exemple de diagramme est représenté sur la figure 1 b. On y distingue les quatre mêmes zones A à D telles que décrites pour la figure 1a.

La détermination de la courbe de solubilité de différentes molécules à cristalliser a fait l'objet de nombreuses études, parmi lesquelles on peut citer celle de A.F. Ducruix, M.M. Riès-Kautt, Methods (1990), 1(1) 25-30 intitulée « Solubility diagram analysis and the relative effectiveness of different ions on protein crystal growth »;

Il existe plusieurs techniques de cristallisation, parmi lesquelles :
- la diffusion de vapeur (en goutte suspendue, assise ou sandwich),
- la dialyse,
- la libre diffusion d'interface, ou encore
- le batch : technique de cristallisation où la molécule à cristalliser est mélangée avec des agents de cristallisation et/ou des additifs appropriés, créant ainsi une solution homogène.

La technique du batch est très utilisée pour la cristallisation de petites molécules, du fait de sa rapidité et de sa simplicité de mise en oeuvre. Cependant, seule une étroite gamme de concentrations de la molécule à cristalliser, ainsi que de l'agent de cristallisation peuvent être échantillonnés au cours d'une même expérimentation de manière à rassembler les conditions opératoires permettant de favoriser la nucléation et/ou la croissance du cristal.

A cet égard, le document WO 2006/099890 A1 décrit un procédé de cristallisation en batch d'une macromolécule reposant sur un contrôle de température systématique de la solution de la macromolécule à cristalliser dans laquelle ont été disposés des cristaux de ladite macromolécule, de manière à ce que les cristaux se situent toujours dans la zone métastable, et ce afin qu'au cours d'une évolution contrôlée de la température de la solution de la macromolécule à cristalliser, les cristaux se développent et grossissent.

Néanmoins, ce procédé de cristallisation se limite uniquement au contrôle :
- d'un seul paramètre de cristallisation qui est la température,
- d'une des deux étapes cruciales à la cristallisation, à savoir la croissance des cristaux ensemencés dans la solution de la macromolécule à cristalliser.

De plus, les cristaux obtenus à l'issue de ce procédé de cristallisation ne sont pas récupérables par des méthodes traditionnelles, telles que le montage des cristaux dans des boucles utilisées en cristallographie. Pour faciliter l'extraction des cristaux, un micromanipulateur est utilisé afin de monter les cristaux dans des capillaires en quartz.

La cristallisation par dialyse implique la mise en place de la molécule à cristalliser dans un dispositif qui est scellé au moyen d'une membrane de dialyse. Cela permet alors à l'eau, des agents de cristallisation, des additifs ou encore des tampons de diffuser de part et d'autre de la membrane de dialyse tout en conservant la molécule à cristalliser dans le dispositif. Le dispositif est placé dans un conteneur approprié qui renferme les agents de cristallisation, les additifs et les tampons. Cette technique par dialyse tient compte aussi bien des effets « salting in » (à basse force ionique, la solubilité de la molécule à cristalliser augmente lorsque la force ionique augmente) et des effets « salting out » (à haute force ionique, la solubilité de la molécule à cristalliser diminue lorsque la force ionique augmente) que du pH.

A cet égard, le document WO 2004/029338 A1 décrit un appareillage de cristallisation par dialyse qui comprend une chambre de cristallisation qui est disposée dans un conteneur et dans laquelle est ménagée une cavité destinée à contenir l'échantillon de cristallisation. Une membrane de dialyse est disposée de manière scellée sur la chambre de cristallisation. Le conteneur comprend un moyen permettant de mettre en contact ou non la membrane avec une solution qui contient des agents de cristallisation à une concentration définie.

Le document US2003/0233978 déccrit aussi un dispositif de cristallisation faisant appel à une membrane de dialyse pour la croissance des cristaux de biomolécules.

Comme cela est décrit dans le document WO 2004/029338 A1, les opérations de cristallisation peuvent avoir lieu simultanément en parallèle dans plusieurs cellules de cristallisation. Le dispositif de cristallisation dans ce document WO 2004/029338 A1 n'est pas conçu pour réaliser en série dans une même cellule de cristallisation des expérimentations de cristallisation en faisant varier la composition de la solution de cristallisation.

Ainsi, d'après l'art antérieur rappelé ci-dessus en matière de techniques de cristallisation, il n'a jamais été développé de dispositif de cristallisation, dans lequel on fait varier, de manière contrôlée, la composition de la solution de cristallisation au cours du processus de cristallisation, pour ainsi créer en série dans une même cellule de cristallisation des conditions de cristallisation tout à fait variées pour un même échantillon contenant la molécule à cristalliser et le faisant donc évoluer au cours de la cristallisation.

La présente invention se propose de fournir un dispositif de cristallisation, dans lequel la cristallisation est mise en oeuvre selon une démarche tout à fait innovante, à savoir en faisant varier de manière contrôlée et *in situ* la composition de la solution de cristallisation. Cela confère l'avantage d'améliorer la cristallisation. En effet, grâce au dispositif de cristallisation selon l'invention, des cristaux d'excellente qualité, de volume important et de la phase cristalline/polymorphe souhaitée sont obtenus.

Cette mise en oeuvre de la cristallisation tout à fait innovante présente aussi l'intérêt de nécessiter un volume de l'échantillon de la molécule à cristalliser utilisé dans une seule expérimentation réduit par rapport aux techniques classiques de cristallisation avec la possibilité de le réutiliser ultérieurement. En effet, l'échantillon n'est pas consommé au cours de la cristallisation et les conditions de cristallisation peuvent être changées de façon réversible.

Ainsi, un premier objet de l'invention est un dispositif de cristallisation d'une molécule à cristalliser comprenant :
- au moins une cellule de cristallisation, la cellule de cristallisation comprenant :
   o une chambre de cristallisation, dans laquelle est ménagée une cavité destinée à recevoir une première solution S1 contenant la molécule à cristalliser et ses germes de cristaux, et éventuellement au moins un tampon, la cavité comportant un fond optique et une ouverture en regard du fond optique,
   o une membrane de dialyse destinée à recouvrir l'ouverture de la cavité de la chambre de cristallisation,
   o un réservoir destiné à venir s'emboîter sur la chambre de cristallisation, de manière à créer un compartiment étanche formé d'une part par le réservoir et d'autre part par la chambre de cristallisation, le compartiment étant destiné à être rempli d'une deuxième solution S2, dite solution de cristallisation qui contient des constituants choisis dans le groupe constitué par les agents de cristallisation, les additifs et les tampons,
- au moins un moyen d'acquisition d'images,
   ledit dispositif de cristallisation étant caractérisé en ce qu'il comprend :
- au moins un moyen d'ajout agencé pour ajouter dans le réservoir des constituants choisis dans le groupe constitué par les agents de cristallisation, les additifs et les tampons à la solution S2
   et/ou
- au moins un moyen de prélèvement agencé pour prélever dans le réservoir tout ou partie de la solution S2.

Grâce au moyen d'ajout et/ou au moyen de prélèvement, la nature des constituants que contient la solution S2 (les agents de cristallisation, les additifs, les tampons) ainsi que la concentration de ces constituants peut varier au cours de la cristallisation.

La composition de la solution S2 peut être ajustée précisément par l'opérateur qui réalise la cristallisation. Pour décider des variations de la composition de la solution S2, l'opérateur s'en réfère notamment à des concepts physico-chimiques déterminés d'après les diagrammes de phases de la molécule à cristalliser évoqués ci-dessus.

Ainsi, le réservoir de la cellule de cristallisation est construit comme une cellule à flux continu.

Grâce au dispositif de cristallisation selon l'invention, une optimisation de la nucléation et de la croissance cristalline peut être obtenue en combinant une méthode de dialyse avec des variations précises de la température et de la composition de la solution S2 qui sont décidées par l'opérateur à partir de contrôles des paramètres de la cristallisation (la température, la concentration de la molécule à cristalliser et la composition de la solution S2) effectués au cours de la cristallisation.

Le moyen d'ajout peut consister en un moyen de pilotage, dit « moyen de pilotage d'ajout » qui est agencé pour ajouter dans le réservoir des constituants choisis dans le groupe constitué par les agents de cristallisation, les additifs et les tampons à la solution S2.

Le moyen de prélèvement peut consister en un moyen de pilotage dit « moyen de pilotage de prélèvement » qui est agencé pour prélever dans le réservoir tout ou partie de la solution S2.

Dans un mode de réalisation, le moyen d'ajout consiste en une pompe péristaltique à multicanaux.

Plus précisément, la pompe péristaltique à multicanaux peut comprendre :
- une pluralité de canaux, dits « canaux secondaires », qui sont immergés chacun dans un réservoir d'une solution Sᵢ de stockage contenant des constituants choisis dans le groupe constitué par les agents de cristallisation, les additifs et les tampons. Les solutions Sᵢ peuvent contenir des constituants différents, mais aussi identiques, éventuellement à des concentrations différentes ;
- un canal, dit « canal d'ajout » qui relie la pluralité des canaux secondaires au réservoir, de manière à ajouter dans le réservoir les agents de cristallisation, les additifs et les tampons des solutions Si.

Dans un autre mode de réalisation de l'invention, le moyen de prélèvement consiste en une pompe péristaltique qui comprend un canal, dit « canal de prélèvement», dans lequel circule tout ou partie de la solution S2 qui a été prélevée dans le réservoir.

Dans un autre mode de réalisation de l'invention, le moyen d'ajout et le moyen de prélèvement consistent en une pompe péristaltique à multicanaux. Dans ce mode de réalisation, la pompe péristaltique à multicanaux peut comprendre :
- une pluralité de canaux, dits « canaux secondaires », qui sont immergés chacun dans un réservoir d'une solution Sᵢ de stockage contenant des constituants choisis dans le groupe constitué par les agents de cristallisation, les additifs et les tampons. Les solutions Si peuvent contenir des constituants différents, mais aussi identiques, éventuellement à des concentrations différentes ;
- un canal, dit « canal d'ajout » qui relie la pluralité des canaux secondaires au réservoir, de manière à ajouter dans le réservoir les constituants choisis dans le groupe constitué par les agents de cristallisation, les additifs et les tampons des solutions Si,
- un canal, dit « canal de prélèvement», dans lequel circule tout ou partie de la solution S2 qui a été prélevée dans réservoir.

Ainsi, au cours de la cristallisation, la composition de la solution S2 évolue, car elle résulte :
- du mélange des solutions Sᵢ qui ont été ajoutées de manière ajustée et contrôlée dans le réservoir de la cellule de cristallisation, mais aussi
- du prélèvement de tout ou partie de la solution S2.

Au cours de la cristallisation, la composition de la solution S2 contenue dans le réservoir de la cellule de cristallisation peut commodément varier (ou autrement dit être ajustée) en fonction des quantités requises en agents de cristallisation et/ou en additifs au fur et à mesure de la cristallisation. Elle peut donc évoluer au cours de la cristallisation, et ce de manière réversible, du fait de la diffusion au travers de la membrane de dialyse des constituants de la solution S2.

Avantageusement, la pompe péristaltique à multicanaux est équipée d'un logiciel spécialement développé pour permettre à l'opérateur de spécifier la nature et la concentration des agents de cristallisation, des additifs et des tampons requis, et donc de réaliser les mélanges appropriés à partir des différentes solutions Sᵢ pour obtenir la solution S2 dont il souhaite disposer à un instant donné de la cristallisation dans le réservoir de la cellule de cristallisation. Le logiciel peut aussi être conçu pour permettre à l'opérateur de spécifier le pH de la solution de cristallisation S2.

De manière préférée, le moyen d'acquisition d'images consiste en un vidéomiscroscope.

Dans un mode avantageux de l'invention, le moyen d'acquisition d'images comporte :
- un vidéomicroscope,
- une caméra couleur numérique,
- un ordinateur équipé d'un logiciel permettant le traitement des images acquises par caméra vidéo.

Dans un autre mode de réalisation de l'invention, le moyen d'acquisition d'images comporte un microscope optique et un appareil photographique ou une caméra vidéo.

D'autres moyens de contrôle de la cristallisation dans la cellule de cristallisation peuvent être envisagés. Il s'agit par exemples de techniques de laser, de mesures de la turbidité, d'interféromètres, de diffraction, d'ultrasonographie, de scintillation, de polarisation, de strioscopie, d'ellipsométrie, de spectrographie Raman, d'holographie.

La chambre de cristallisation peut être réalisée en acier inoxydable, en verre ou en quartz.

Le dispositif de cristallisation peut en outre comprendre au moins un moyen de contrôle et de variation de la température du dispositif de cristallisation.

Dans un mode de réalisation de l'invention, le moyen de contrôle et de variation de la température est basé sur la technologie Peltier. Il peut s'agir d'une Cellule à Effet Peltier (CEP), appelée aussi module thermoélectrique.

Le dispositif de cristallisation peut comprendre au moins un moyen de mesure de la concentration de la molécule à cristalliser dans la solution S1.

Le dispositif de cristallisation peut aussi comprendre au moins un moyen de caractérisation de la molécule à cristalliser en termes de taille/masse et de la distribution des tailles de particules de la molécule à cristalliser se formant/diffusant dans la solution S1.

De manière préférée, le dispositif de cristallisation comprend en outre un système de mesure de l'absorbance UV et un système de diffusion de la lumière dans la chambre de cristallisation. La mesure de l'absorbance UV permet de déterminer la courbe de solubilité telle que définie ci-avant.

La diffusion de la lumière caractérise le rapport taille/masse et la distribution des tailles de particules de la molécule à cristalliser se formant et/ ou diffusant dans la solution S1. La nucléation peut ainsi être détectée et la limite supérieure de la zone métastable (à savoir la ligne entre la zone A et la zone C des diagrammes de phases des figures fig. 1a et fig. 1b) peut être identifiée. Dans ce mode de réalisation, le fond optique de la cellule de cristallisation est de préférence en quartz.

Dans un mode de réalisation de l'invention, le dispositif de cristallisation comprend en outre un micromanipulateur permettant d'extraire les cristaux de la cellule de cristallisation.

Dans un mode de réalisation envisageable de l'invention, le dispositif de cristallisation comporte une pluralité de cellules de cristallisation qui sont disposées sur un carrousel semi-automatisé.

La membrane de dialyse peut être :
- en cellulose (par exemple en cuprophane, à savoir une cellulose régénérée), en cellulose modifiée telle que l'acétate de cellulose, l'hémophane, ou encore en cellulose modifiée synthétiquement,
- une membrane synthétique, par exemple en polysulfone, en polyamide polyacrylonitrile, en copolymères d'acrylonitrile et sulfonate de sodium de methallyl, en polyméthylmétacrylate (PMMA), en ethylènevinylalcool (EVOH) ou encore en polycarbonate (PC).

Une membrane en cellulose présente les propriétés suivantes : finesse, pores de petit diamètre permettant l'élimination de substances de poids moléculaire faible, un faible coût, une forte réactivité chimique (du fait des groupes hydroxyle), une faible biocompatibilité.

La cellulose modifiée présente les propriétés suivantes : une réactivité chimique moindre, une bonne biocompatibilité, une substitution des groupes hydroxyle, une augmentation de la taille des pores, une augmentation de la perméabilité hydraulique, une élimination de substances de plus grand poids moléculaire.

Les membranes synthétiques présentent les propriétés suivantes : une réactivité chimique faible (car dépourvues de groupes hydroxyle), une bonne biocompatibilité, une taille des pores élevée, une perméabilité hydraulique, une élimination de substances de poids moléculaire important.

De manière préférée, le fond optique de la cellule de cristallisation est en polycarbonate. Il peut aussi être en verre ou en quartz.

La cavité ménagée dans la chambre de cristallisation a un volume avantageusement compris entre 5 et 200µL.

Selon un mode préféré de l'invention, le réservoir de la cellule de cristallisation du dispositif de cristallisation tel que décrit ci-dessus comprend un bouchon, équipé d'une fenêtre optique, qui est fixé à l'extrémité opposée à la membrane de dialyse. Le bouchon comprend avantageusement un joint destiné à sceller de manière hermétique le réservoir.

Selon un mode de réalisation préféré de l'invention, la cellule de cristallisation du dispositif de cristallisation tel que décrit ci-dessus comprend en outre une surchambre agencée de manière à être fixée entre la chambre de cristallisation et le réservoir et sur laquelle est disposée la membrane de dialyse. Avantageusement, le réservoir est vissé sur la surchambre. De plus, la surchambre peut être équipée d'un joint pour sceller de manière hermétique la surchambre sur la chambre de cristallisation.

Ce mode de réalisation de la cellule de cristallisation se décomposant en trois parties (la chambre de cristallisation, la surchambre et le réservoir) constitue un autre objet de la présente invention.

Plus précisément, l'invention concerne une cellule de cristallisation comprenant :
- une chambre de cristallisation, dans laquelle est ménagée une cavité destinée à recevoir une première solution S1 contenant la molécule à cristalliser et ses germes de cristaux, et éventuellement au moins un tampon, la cavité comportant un fond optique et une ouverture en regard du fond optique,
- une membrane de dialyse destinée à recouvrir l'ouverture de la cavité de la chambre de cristallisation,
- un réservoir destiné à venir s'emboîter sur la chambre de cristallisation, de manière à créer un compartiment étanche formé d'une part par le réservoir et d'autre part par la chambre de cristallisation, le compartiment étant destiné à être rempli d'une deuxième solution S2, dite solution de cristallisation qui contient des constituants choisis dans le groupe constitué par les agents de cristallisation, les additifs et les tampons,
qui se caractérise en ce que la cellule de cristallisation comprend en outre une surchambre agencée de manière à être fixée entre la chambre de cristallisation et le réservoir et sur laquelle est disposée la membrane de dialyse. Le réservoir peut comprendre un bouchon équipé d'une fenêtre optique qui est fixé à l'extrémité opposée à la membrane de dialyse.

Cette configuration en trois parties de la cellule de cristallisation présente l'avantage de pouvoir aisément récupérer les cristaux à l'issue de la cristallisation.

En effet, une fois que les cristaux sont formés, la solution de cristallisation S2 est retirée, par exemple par aspiration au moyen d'une pompe péristaltique. Le réservoir est ensuite dévissé. La surchambre reste assemblée à la chambre de cristallisation de manière à préserver les cristaux de tout dommage mécanique ou de dessèchement. La membrane de dialyse est alors découpée, par exemple à l'aide d'un scalpel, et les cristaux sont aisément récupérés à l'aide d'une boucle cristallographique en nylon.

L'invention concerne aussi l'utilisation du dispositif de cristallisation d'une molécule à cristalliser tel que décrit ci-dessus pour la cristallisation de molécules de plusieurs milliers de Daltons à plusieurs centaines de milliers de Daltons. Il peut s'agir de séquences d'acides nucléiques d'ADN ou d'ARN, de fragments de virus, de protéines, de complexes de protéines, de complexes protéine-ARN, de complexes protéine-ligand, ou encore de polypeptides.

L'invention concerne aussi un procédé de cristallisation s'effectuant au moyen du dispositif de cristallisation tel que décrit ci-dessus.

Selon un premier mode de réalisation du procédé de cristallisation, la concentration P en agents de cristallisation et/ou additifs demeure constante et l'on a recours au diagramme de phases de la molécule à cristalliser établi en fonction de la concentration en ladite molécule à cristalliser et de la température tel que représenté à la figure 1 a.

Plus précisément, le procédé de cristallisation d'une molécule à cristalliser selon ce premier mode de réalisation comprend les étapes suivantes :
a) On dispose :
   - d'une première solution S1 de ladite molécule à cristalliser dans la chambre de cristallisation d'une cellule de cristallisation d'un dispositif de cristallisation tel que décrit ci-dessus, et ce à une première température T1 et à une concentration C1 de la molécule à cristalliser dans la solution S1, de telle sorte que la molécule à cristalliser se trouve dans la zone de nucléation spontanée ou sur la limite supérieure de la zone métastable du diagramme de phases de ladite molécule à cristalliser établi en fonction des paramètres de la concentration de la molécule à cristalliser et de la température ;
   - d'une deuxième solution S2, dite solution de cristallisation, dans le compartiment de la cellule de cristallisation, ladite solution de cristallisation S2 contenant au moins un agent de cristallisation et/ou un additif à une concentration P constante,
      de manière à ce que l'agent de cristallisation et/ou l'additif diffuse dans la solution S1 et de telle sorte qu'apparaissent des germes de la molécule à cristalliser.
b) on augmente la température de la cellule de cristallisation à une température T2 de telle sorte que la nucléation est arrêtée et que la molécule à cristalliser se trouve dans la zone métastable du diagramme de phases de la molécule à cristalliser.
c) On laisse grossir les germes de cristaux à la température T2 jusqu'à l'obtention d'un premier point d'équilibre E1 (tel que figurant sur la figure 1 a), où la taille des cristaux demeure constante, la concentration de la molécule à cristalliser dans la solution S1 atteinte étant alors la concentration C2.
d) On abaisse la température de la chambre de cristallisation à une température T3, de telle sorte que les cristaux présents dans la chambre de cristallisation se situent toujours dans la zone métastable du diagramme de phases de la molécule à cristalliser.
e) On laisse grossir les germes de cristaux et les cristaux à la température T3 jusqu'à l'obtention d'un deuxième point d'équilibre E2 (tel que figurant sur la figure 1 a) où la taille des cristaux demeure constante, la concentration de la molécule à cristalliser dans la solution S1 atteinte étant alors la concentration C3.
f) On répète les étapes c) à e) jusqu'à l'obtention de cristaux de la taille souhaitée de la molécule à cristalliser.
g) On récupère les cristaux obtenus à l'issue de l'étape f).

La figure 1 a représente le mode de réalisation du procédé selon l'invention dans lequel à l'étape a), la molécule à cristalliser se trouve sur la limite supérieure de la zone métastable du diagramme de phases de ladite molécule à cristalliser établi en fonction des paramètres de la température et de la concentration de la molécule à cristalliser.

A l'étape f), on entend par taille souhaitée, une taille de l'ordre de 0,1 mm si les cristaux sont destinés à de la cristallographie aux rayons X, et de l'ordre de 1,0 mm si les cristaux sont destinés à de cristallographie aux neutrons.

Les cristaux sont aisément récupérés à l'étape g) du procédé selon l'invention, du fait que la solution de cristallisation S2, ainsi que le réservoir de la cellule de cristallisation sont aisément retirés. Puis, à l'aide d'un scalpel chirurgical, une incision peut être effectuée sur la membrane suivant l'ouverture de la chambre de cristallisation pour la retirer au moyen d'une pince.

De cette manière, les perturbations mécaniques de l'échantillon contenant la molécule à cristalliser sont minimisées. Ensuite, les cristaux sont montés directement dans des boucles de tailles appropriées en fibre utilisées conventionnellement en cristallographie. Toute cette procédure peut être effectuée en visualisant la cellule de cristallisation sous un microscope optique que peut comprendre le dispositif de cristallisation selon l'invention.

Selon un deuxième mode de réalisation du procédé de cristallisation, la température T de la cellule de cristallisation est maintenue constante et l'on a recours au diagramme de phases de la molécule à cristalliser établi en fonction de la concentration en ladite molécule à cristalliser et de la concentration en agents de cristallisation et/ou d'additifs tel que représenté à la figure 1 b.

Plus précisément, le procédé de cristallisation d'une molécule à cristalliser selon ce deuxième mode de réalisation comprend les étapes suivantes :
a) On dispose :
   - d'une première solution S1 de ladite molécule à cristalliser dans la chambre de cristallisation d'une cellule de cristallisation d'un dispositif de cristallisation tel que décrit ci-dessus, et ce à une température constante T de la cellule de cristallisation et à une concentration C1 en la molécule à cristalliser, de telle sorte que la molécule à cristalliser se trouve dans la zone de nucléation spontanée ou sur la limite supérieure de la zone métastable du diagramme de phases de ladite molécule à cristalliser établi en fonction des paramètres de la concentration de la molécule à cristalliser et de la concentration en agent de cristallisation et/ou additif;
   - d'une deuxième solution S2, dite solution de cristallisation contenant au moins un agent de cristallisation et/ou un additif à la concentration P1 dans le compartiment de la cellule de cristallisation,
      de manière à ce que l'agent de cristallisation et/ou l'additif diffuse dans la solution S1, de telle sorte qu'apparaissent des germes de la molécule à cristalliser.
b) On diminue la concentration de l'agent de cristallisation et/ou de l'additif à une concentration P2, de telle sorte que la nucléation est arrêtée et que la molécule à cristalliser se trouve dans la zone métastable dudit diagramme de phases de la molécule à cristalliser.
c) On laisse grossir les germes de cristaux à la concentration P2 de l'agent de cristallisation et/ou de l'additif jusqu'à l'obtention d'un premier point d'équilibre E1 (tel que figurant sur la figure 1 b), où la taille des cristaux demeure constante, la concentration de la molécule à cristalliser dans la solution S1 atteinte étant alors la concentration C2.
d) On augmente la concentration de l'agent de cristallisation et/ou de l'additif à une concentration P3, de telle sorte que les cristaux présents dans la chambre de cristallisation se situent toujours dans la zone métastable dudit diagramme de phases de la molécule à cristalliser,
e) On laisse grossir les germes de cristaux et les cristaux à la concentration P3 de l'agent de cristallisation et/ou de l'additif jusqu'à l'obtention d'un deuxième point d'équilibre E2 (tel que figurant sur la figure 1 b) où la taille des cristaux demeure constante, la concentration de la molécule à cristalliser dans la solution S1 atteinte est concentration C3,
f) On répète les étapes c) à e) jusqu'à l'obtention de cristaux de taille souhaitée de la molécule à cristalliser.
g) On récupère les cristaux obtenus à l'issue de l'étape f).

La figure 1b représente le mode de réalisation du procédé selon l'invention dans lequel à l'étape a), la molécule à cristalliser se trouve sur la limite supérieure de la zone métastable du diagramme de phases de ladite molécule à cristalliser établi en fonction des paramètres de la concentration de la molécule à cristalliser et de la concentration en agent de cristallisation et/ou additif.

A l'étape f), on entend par taille souhaitée, une taille de l'ordre de 0,1 mm si les cristaux sont destinés à de la cristallographie aux rayons X et de l'ordre de 1,0 mm si les cristaux sont destinés à de cristallographie aux neutrons.

Selon un troisième mode de réalisation du procédé de cristallisation, on a recours à un diagramme de phases de la molécule à cristalliser établi en fonction de :
- la concentration en ladite molécule à cristalliser,
- la concentration en agents de cristallisation et/ou en additifs, et
- la température.
Ce diagramme de phases est donc un diagramme en trois dimensions.

Ainsi, selon ce troisième mode de réalisation, on peut agir simultanément sur les paramètres de température et de concentration en agents de cristallisation et/ou d'additifs.

Les conditions du procédé de cristallisation selon ce troisième mode de réalisation sont les mêmes que celles détaillées pour le premier et le deuxième modes de réalisation du procédé, à la différence que l'on agit simultanément sur les deux paramètres précités.

Ainsi, à l'étape a) du procédé de cristallisation selon ce troisième mode de réalisation, la molécule à cristalliser se trouve dans la zone de nucléation spontanée du diagramme de phases en trois dimensions.

Puis, pour contrôler la croissance ordonnée des cristaux, on recherche les conditions permettant de se situer dans la zone métastable de ce diagramme de phases en trois dimensions.

De plus, la connaissance du diagramme de phases et le contrôle précis des paramètres de cristallisation tels que la température et la concentration en agent de cristallisation et/ou additifs tels que décrits dans la présente invention permet, au cours du procédé de cristallisation selon l'invention, de diminuer le nombre de cristaux et leurs défauts macroscopiques, ainsi que de sélectionner la nucléation et/ou la croissance de la phase souhaitée.

De plus, le procédé de cristallisation selon l'invention présente l'avantage de pouvoir induire les phénomènes physiques suivants :
- le mûrissement cinétique,
- la transition des phases.

Si dans une solution d'une molécule à cristalliser, il y a plusieurs cristaux de la même phase et qu'ils ont été formés à des moments différents, ils ont des tailles différentes.

A température constante, un petit cristal a une solubilité plus grande qu'un grand cristal. La conséquence du mûrissement d'Ostwald (phénomène isotherme) réside dans le fait qu'au cours du temps (plusieurs semaines ou mois), les petits cristaux disparaissent au profit de gros cristaux. Si l'on impose des fluctuations contrôlées de température et/ou de concentration en agent de cristallisation et/ou additif, le mûrissement cinétique s'installe et entraîne la disparition plus rapide des cristaux les plus petits.

Il en est de même pour les défauts macroscopiques des cristaux tels que les cristaux satellites collés sur des monocristaux. En induisant des fluctuations contrôlées de température et/ou de concentration en agent de cristallisation et/ou additif, ces satellites peuvent être complètement dissous au profit de la croissance de gros monocristaux.

Les fluctuations contrôlées de température et/ou de concentration en agent de cristallisation et/ou additif peuvent être aussi à l'origine du phénomène de transition des phases (disparition d'une phase au profit d'une autre phase). Ces phases peuvent être des polymorphes, des solvates, des solides microcristallins d'autres phases et des liquides amorphes.

Avantageusement, la molécule à cristalliser est choisie parmi des séquences d'acides nucléiques d'ADN ou d'ARN, de fragments de virus, de protéines, de complexes des protéines, de complexes protéine-ARN, de complexes protéine-ligand, ou encore de polypeptides.

A titre d'exemples de protéines cristallisées dans le cadre de l'invention, on peut citer la pyrophosphatase inorganique de levure et l'urate oxydase de *Aspergillus flavus* qui peut être co-cristallisée en présence de différents inhibiteurs tels que 8-azaxanthine, 9-méthyle acide urique, 8-nitroxanthine, ainsi que son substrat naturel : l'acide urique.

A titre d'exemple, la pyrophosphatase inorganique de levure est solubilisée dans un tampon : le MES, à concentration de 30 mM. Cela permet de maintenir un pH de la solution de cristallisation à 6. La solution de cristallisation S2 est une solution comprenant 15% de MPD, et 0,5mM de NaH₂PO₄, 1mM de MnCl₂, et 30mM de tampon MES de pH 6.

A titre d'autre exemple, l'urate oxydase est solubilisée dans le tampon Tris à une concentration de 100mM, de manière à avoir un pH 8,5. La solution S2 est une solution comprenant 5% de PEG8000, 100mM de NaCl, et 100 mM de tampon Tris de pH 8,5.

Le procédé de cristallisation selon l'invention présente tout son intérêt non seulement dans la recherche fondamentale, mais aussi du fait que les structures tridimensionnelles de macromolécules biologiques, particulièrement celles des protéines sont cruciales pour le développement de nouveaux composés pharmaceutiques.

En effet, beaucoup de cibles de médicaments sont des protéines membranaires intégrales qui sont expérimentalement particulièrement exigeantes. Avec de telles cibles difficiles à produire, les méthodes d'automatisation de cristallisation existantes sont souvent inefficaces.

Grâce au procédé de cristallisation selon l'invention, il est possible de « façonner » la taille du cristal, sa qualité de diffraction et sa phase cristalline tout en réduisant significativement le temps, l'effort et la quantité de la molécule à cristalliser exigée pour la détermination de sa structure.

L'évolution de la taille des cristaux est mesurée à l'aide du dispositif d'acquisition d'images, par exemple en prenant des photographies des cristaux environ toutes les 20 à 30 minutes quand la croissance des cristaux débute, puis toutes les 2 à 3 heures, lorsqu'elle est sur le point de s'achever. Les photographies peuvent être analysées à l'aide d'un logiciel d'analyses d'images spécialement adapté.

Il est à noter que l'ensemble des étapes du procédé de cristallisation tel que décrit ci-dessus peut s'étaler sur une durée atteignant deux mois, en particulier si l'on souhaite disposer de volumes importants de cristaux de la molécule à cristalliser qui sont nécessaires en cristallographie des protéines aux neutrons.

Pour la cristallographie aux rayons X, une durée d'une à deux semaines est suffisante.

Aussi, le choix des températures au cours de ces étapes dépend de la nature des molécules à cristalliser et de leur stabilité thermique.

A titre d'exemple, la cristallisation des protéines est un processus très délicat qui dépend d'un grand nombre de variables environnementales (par exemple la concentration de la protéine et d'agent de cristallisation, la température, le pH) et des facteurs cinétiques qui sont difficilement contrôlables.

Dans le cas de l'urate d'oxydase, l'intervalle de températures optimal est compris entre 5°C et 28°C. Au dessus de 28°C (par exemple à 30°C), la protéine ne demeure pas stable suffisamment longtemps et elle commence à se dégrader.

Ainsi, le procédé de cristallisation selon l'invention est parfaitement adapté pour la cristallisation de molécules très diversifiées, à savoir aussi bien pour des molécules de poids moléculaire important que pour des molécules de poids moléculaire faible, telles que des composés pharmaceutiques.

L'invention sera mieux comprise à l'aide de la description détaillée qui est exposée ci-dessous au regard du dessin annexé.
La figure 1 a représente un diagramme de phases d'une molécule à cristalliser établi en fonction des paramètres de la concentration de la molécule à cristalliser et de la température. Il s'agit ici d'une protéine avec une solubilité directe.
La figure 1b représente un diagramme de phases d'une molécule à cristalliser établi en fonction des paramètres de la concentration de la molécule à cristalliser et de la concentration en agent de cristallisation et/ou additif.
La figure 2a représente une vue schématique éclatée et en perspective d'une cellule de cristallisation selon l'invention.
La figure 2b représente une vue schématique en perspective de la cellule de cristallisation représentée à la figure 2a.
La figure 3a représente une vue schématique de face d'un dispositif de cristallisation selon l'invention.
La figure 3b représente une vue schématique de côté du dispositif de cristallisation représenté à la figure 3a.

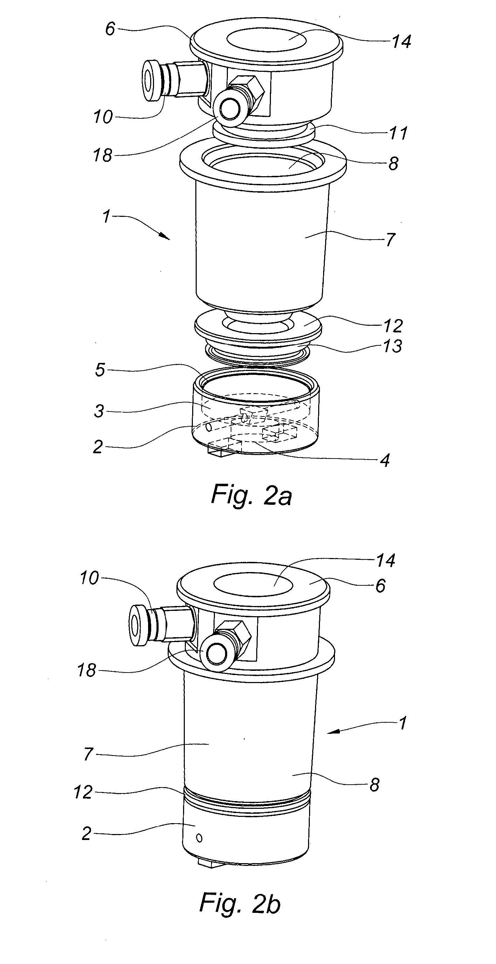

Sur les figures 2a et 2b est représentée une cellule de cristallisation 1 selon l'invention. Cette cellule de cristallisation 1 comprend :
- une chambre de cristallisation 2, dans laquelle est ménagée une cavité 3 destinée à recevoir une première solution S1 de la molécule à cristalliser. La cavité 3 comporte un fond optique 4 et une ouverture 5 en regard du fond optique 4.
- une membrane de dialyse (non visible) destinée à recouvrir l'ouverture 5 de la cavité 3 de la chambre de cristallisation 2,
- un réservoir 7 destiné à venir s'emboîter sur la chambre de cristallisation 2, de manière à créer un compartiment 8 étanche formé d'une part par le réservoir 7 et d'autre part par la chambre de cristallisation 2, le compartiment 8 étant rempli d'une deuxième solution S2 dite solution de cristallisation,
- une surchambre 12 équipée d'un joint 13,
- un bouchon 6 équipé d'une fenêtre optique 14, d'un joint 11, d'un premier embout 10 et d'un deuxième embout 18 destinés respectivement à être relié à un canal d'ajout et à un canal de prélèvement d'une pompe péristaltique non représentée sur les figures 2a et 2b.

La membrane de dialyse est maintenue en place sur la chambre de cristallisation 2 au moyen d'une surchambre 12 et d'un joint 13. En effet, la membrane de dialyse a été placée sur la surchambre 12 au moyen du joint 13 et l'ensemble a ensuite été disposé sur la chambre de cristallisation 2.

La molécule à cristalliser présente dans la solution de cristallisation S1 ne diffuse pas au travers de la membrane de dialyse.

Par effet d'osmose et d'agitation moléculaire, les agents de cristallisation, les additifs et les tampons de la solution de cristallisation S2 traversent la membrane de dialyse, tandis que les molécules cristallisées de la solution de cristallisation S1 sont retenues dans la chambre de cristallisation 2.

Il s'établit un équilibre osmotique de part et d'autre de la membrane de dialyse entre les composés présents dans la solution de cristallisation S2 et les composés présents dans la solution S1 qui consistent non seulement en la molécule à cristalliser mais aussi en les agents de cristallisation et additifs précités ainsi que les tampons qui ont diffusé au travers de la membrane de dialyse.

De plus, la diffusion des agents de cristallisation, des additifs et des tampons de la solution S2 au travers la membrane de dialyse permet d'obtenir de manière contrôlée des cristaux de la molécule à cristalliser, puisque grâce à cette diffusion contrôlée, les cristaux présents dans la solution S1 peuvent se situer à la frontière entre les zones C et A des diagrammes de phases tels que représentés aux figures 1 a et 1 b.

Ainsi le procédé de cristallisation selon l'invention permet de contrôler à la fois la nucléation spontanée en se situant à la limite supérieure de la zone métastable, et la croissance des cristaux en se situant dans la zone métastable.

La membrane de dialyse procure l'avantage à la cellule de cristallisation 1 de pouvoir aisément faire varier et de manière réversible les constituants de la solution S1, de par la possibilité de la diffusion de manière réversible des agents de cristallisation, des additifs et des tampons de la solution S2 au travers de la membrane de dialyse, et ce aisément en ajoutant des agents de cristallisation, des additifs et des tampons et/ou en prélevant tout ou partie de la solution de cristallisation S2 au fur et à mesure du procédé de cristallisation de la molécule à cristalliser, plus précisément sous des conditions optimales de cristallisation (à savoir provoquant la nucléation et/ou la croissance de cristaux) qui sont déterminées à l'aide des diagrammes de phases de la molécule à cristalliser tel que, par exemple, représentés aux figures 1 a et 1 b.

Ainsi, grâce à la cellule de cristallisation 1, on peut aisément étudier toute combinaison de concentration des constituants de la solution de cristallisation S2, de température, de telle sorte que la quantité de la molécule à cristalliser dans la solution S1 puisse rester constante durant toute la cristallisation.

La cellule de cristallisation 1 permet l'exploration de la multitude des conditions de cristallisation avec le même échantillon de molécule à cristalliser. Cela procure l'avantage d'obtenir des cristaux de la taille, de la qualité de diffraction et de la phase cristalline souhaitées, et ce de manière économique (en particulier pour le matériel) et avec un gain de temps considérable comparé aux techniques actuelles.

Les cristaux de la solution S1 sont en effet exposés en permanence à des conditions optimales de cristallisation par approvisionnement en continu des constituants de la solution de cristallisation S2 au travers la membrane de dialyse.

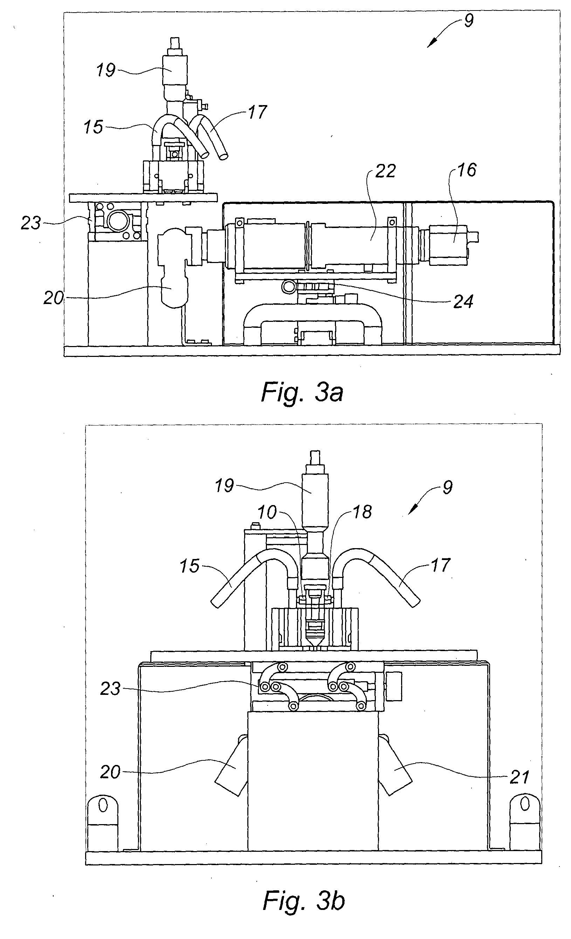

Sur les figures 3a et 3b est représenté un dispositif de cristallisation 9 selon l'invention qui comprend :
- un vidéomicroscope 22,
- une caméra couleur numérique 16 qui est reliée à un ordinateur (non représenté),
- des supports 23,24,
- des diodes électroluminescentes 19,20,21.

L'embout d'entrée 10 du bouchon 6 est relié à un canal d'entrée 15 d'une pompe péristaltique (non représentée). Cela permet d'ajouter dans le réservoir 7 à la solution S2 des constituants choisis dans le groupe constitué par les agents de cristallisation, les additifs et les tampons. L'embout de sortie 18 du bouchon 6 est relié à un canal de sortie 17 de la pompe péristaltique (non représentée). Cela permet de prélever tout ou partie de la solution S2 dans le réservoir 7.

## Revendications

1. Dispositif de cristallisation (9) d'une molécule à cristalliser qui comprend :
- au moins une cellule de cristallisation (1), la cellule de cristallisation (1) comprenant :
• une chambre de cristallisation (2), dans laquelle est ménagée une cavité (3) destinée à recevoir une première solution S1 contenant la molécule à cristalliser et ses germes de cristaux, et éventuellement au moins un tampon, la cavité (3) comportant un fond optique (4) et une ouverture (5),
• une membrane de dialyse,
• un réservoir (7) destiné à venir s'emboîter sur la chambre de cristallisation (2), de manière à créer un compartiment étanche formé d'une part par le réservoir (7) et d'autre part par la chambre de cristallisation (2), le compartiment étant destiné à être rempli d'une deuxième solution S2, dite solution de cristallisation qui contient des constituants choisis dans le groupe constitué par les agents de cristallisation, les additifs et les tampons,
- au moins un moyen d'acquisition d'images,
au moins un moyen d'ajout agencé pour ajouter dans le réservoir (7) des constituants choisis dans le groupe constitué par les agents de cristallisation, les additifs et les tampons à la solution S2 et/ou
- au moins un moyen de prélèvement agencé pour prélever dans le réservoir (7) tout ou partie de la solution S2,
ledit dispositif de cristallisation (9) est **caractérisé en ce que** l'ouverture (5) est en regard du fond optique (4) et **en ce que** la membrane de dialyse est destinée à recouvrir l'ouverture (5) de la cavité (3) de la chambre de cristallisation (2).

2. Dispositif de cristallisation (9) selon la revendication 1, **caractérisé en ce que** le moyen d'ajout consiste en un moyen de pilotage agencé pour ajouter dans le réservoir (7) des constituants choisis dans le groupe constitué par les agents de cristallisation, les additifs et les tampons à la solution S2.

3. Dispositif de cristallisation (9) selon l'une quelconque des revendications précédentes, **caractérisé en ce que** le moyen de prélèvement consiste en un moyen de pilotage qui est agencé pour prélever dans le réservoir tout ou partie de la solution S2.

4. Dispositif de cristallisation (9) selon l'une quelconque des revendications précédentes, **caractérisé en ce que** le moyen d'ajout et le moyen de prélèvement consistent en une pompe péristaltique à multicanaux.

5. Dispositif de cristallisation (9) selon l'une quelconque des revendications précédentes, **caractérisé en ce qu'**il comprend en outre au moins un moyen de contrôle et de variation de la température du dispositif de cristallisation (9).

6. Dispositif de cristallisation (9) selon la revendication 5, **caractérisé en ce que** le moyen de contrôle et de variation de la température est une Cellule à Effet Peltier.

7. Dispositif de cristallisation (9) selon l'une quelconque des revendications précédentes, **caractérisé en ce qu'**il comprend en outre au moins un moyen de mesure de la concentration de la molécule à cristalliser dans la solution S1.

8. Dispositif de cristallisation (9) selon l'une quelconque des revendications précédentes, **caractérisé en ce que** la cellule de cristallisation (1) comprend une surchambre (12) agencée de manière à être fixée entre la chambre de cristallisation (2) et le réservoir (7) et sur laquelle est disposée la membrane de dialyse.

9. Dispositif de cristallisation (9) selon l'une quelconque des revendications précédentes, **caractérisé en ce que** le réservoir (7) comprend un bouchon (6), équipé d'une fenêtre optique (14), qui est fixé à l'extrémité opposée à la membrane de dialyse.

10. Dispositif de cristallisation (9) selon l'une quelconque des revendications précédentes, **caractérisé en ce que** la membrane de dialyse est une membrane en cellulose ou une membrane synthétique.

11. Dispositif de cristallisation (9) selon l'une quelconque des revendications précédentes, **caractérisé en ce que** le fond optique (4) est en polycarbonate, en quartz ou en verre.

12. Procédé de cristallisation d'une molécule à cristalliser **caractérisé en ce qu'**il comprend les étapes suivantes :
a) On dispose :
- d'une première solution S1 de ladite molécule à cristalliser dans la chambre de cristallisation (2) de la cellule de cristallisation (1) d'un dispositif de cristallisation (9) selon l'une quelconque des revendications 1 à 11, et ce à une première température T1 et à une concentration C1 de la molécule à cristalliser dans la solution S1, de telle sorte que la molécule à cristalliser se trouve dans la zone de nucléation spontanée ou sur la limite supérieure de la zone métastable du diagramme de phases de ladite molécule à cristalliser établi en fonction des paramètres de la concentration de la molécule à cristalliser et de la température ;
- d'une deuxième solution S2, dite solution de cristallisation, dans le compartiment (8) de la cellule de cristallisation (1), ladite solution de cristallisation S2 contenant au moins un agent de cristallisation et/ou un additif à une concentration P constante,
de manière à ce que l'agent de cristallisation et/ou l'additif diffuse dans la solution S1 et de telle sorte qu'apparaissent des germes de la molécule à cristalliser.
b) on augmente la température de la cellule de cristallisation (1) à une température T2 de telle sorte que la nucléation est arrêtée et que la molécule à cristalliser se trouve dans la zone métastable du diagramme de phases de la molécule à cristalliser.
c) On laisse grossir les germes de cristaux à la température T2 jusqu'à l'obtention d'un premier point d'équilibre E1, où la taille des cristaux demeure constante, la concentration de la molécule à cristalliser dans la solution S1 atteinte étant alors la concentration C2.
d) On abaisse la température de la chambre de cristallisation (2) à une température T3, de telle sorte que les cristaux présents dans la chambre de cristallisation (2) se situent toujours dans la zone métastable du diagramme de phases de la molécule à cristalliser.
e) On laisse grossir les germes de cristaux et les cristaux à la température T3 jusqu'à l'obtention d'un deuxième point d'équilibre E2 où la taille des cristaux demeure constante, la concentration de la molécule à cristalliser dans la solution S1 atteinte étant alors la concentration C3.
f) On répète les étapes c) à e) jusqu'à l'obtention de cristaux de la taille souhaitée de la molécule à cristalliser.
g) On récupère les cristaux obtenus à l'issue de l'étape f).

13. Procédé de cristallisation d'une molécule à cristalliser **caractérisé en ce qu'**il comprend les étapes suivantes :
a) On dispose :
- d'une première solution S1 de ladite molécule à cristalliser dans la chambre de cristallisation (2) de la cellule de cristallisation (1) d'un dispositif de cristallisation (9) selon l'une quelconque des revendications 1 à 11, et ce à une température constante T de la cellule de cristallisation (1) et à une concentration C1, de telle sorte que la molécule à cristalliser se trouve dans la zone de nucléation spontanée ou sur la limite supérieure de la zone métastable du diagramme de phases de ladite molécule à cristalliser établi en fonction des paramètres de la concentration de la molécule à cristalliser et de la concentration en agent de cristallisation et/ou additif ;
- d'une deuxième solution S2, dite solution de cristallisation contenant au moins un agent de cristallisation et/ou un additif à la concentration P1 dans le compartiment (8) de la cellule de cristallisation (1),
de manière à ce que l'agent de cristallisation et/ou l'additif diffuse dans la solution S1, de telle sorte qu'apparaissent des germes de la molécule à cristalliser.
b) On diminue la concentration de l'agent de cristallisation et/ou de l'additif à une concentration P2, de telle sorte que la nucléation est arrêtée et que la molécule à cristalliser se trouve dans la zone métastable dudit diagramme de phases de la molécule à cristalliser.
c) On laisse grossir les germes de cristaux à la concentration P2 de l'agent de cristallisation et/ou de l'additif jusqu'à l'obtention d'un premier point d'équilibre E1, où la taille des cristaux demeure constante, la concentration de la molécule à cristalliser dans la solution S1 atteinte étant alors la concentration C2.
d) On augmente la concentration de l'agent de cristallisation et/ou de l'additif à une concentration P3, de telle sorte que les cristaux présents dans la chambre de cristallisation (2) se situent toujours dans la zone métastable dudit diagramme de phases de la molécule à cristalliser,
e) On laisse grossir les germes de cristaux et les cristaux à la concentration P3 de l'agent de cristallisation et/ou de l'additif jusqu'à l'obtention d'un deuxième point d'équilibre E2 où la taille des cristaux demeure constante, la concentration de la molécule à cristalliser dans la solution S1 atteinte est concentration C3,
f) On répète les étapes c) à e) jusqu'à l'obtention de cristaux de taille souhaitée de la molécule à cristalliser.
g) On récupère les cristaux obtenus à l'issue de l'étape f).

## Patentansprüche

1. Kristallisationsvorrichtung (9) für ein zu kristallisierendes Molekül, die Folgendes umfasst:
- mindestens eine Kristallisationszelle (1), wobei die Kristallisationszelle (1) Folgendes umfasst:
-- eine Kristallisationskammer (2), in der ein Hohlraum (3) angelegt ist, der dazu vorgesehen ist, eine erste Lösung S1 aufzunehmen, die das zu kristallisierende Molekül und seine Kristallkeime und gegebenenfalls mindestens einen Puffer enthält, wobei der Hohlraum (3) einen optischen Boden (4) und eine Öffnung (5) aufweist,
-- eine Dialysemembran,
-- ein Reservoir (7), das dazu vorgesehen ist, auf die Kristallisationskammer (2) eingefügt zu werden, um einen dichten Raum zu erzeugen, der einerseits von dem Reservoir (7) und andererseits von der Kristallisationskammer (2) gebildet wird, wobei der Raum dazu vorgesehen ist, mit einer zweiten Lösung S2 gefüllt zu werden, eine so genannte Kristallisationslösung, die Bestandteile enthält, die aus der Gruppe beinhaltend Kristallisationsmittel, Additive und Puffer ausgewählt sind,
- mindestens eine Bilderfassungseinrichtung,
- mindestens Zugabeeinrichtung, die zum Zugeben von Bestandteilen, die aus der Gruppe beinhaltend Kristallisationsmittel, Additive und Puffer ausgewählt sind, zu der Lösung S2 in dem Reservoir (7) eingerichtet ist, und/oder
- mindestens eine Entnahmeeinrichtung, die zum Entnehmen der gesamten oder eines Teils der Lösung S2 aus dem Reservoir (7) eingerichtet ist,
wobei die besagte Kristallisationsvorrichtung (9) **dadurch gekennzeichnet ist, dass** die Öffnung (5) dem optischen Boden (4) gegenüberliegt und dass die Dialysemembran dazu vorgesehen ist, die Öffnung (5) des Hohlraums (3) der Kristallisationskammer (2) abzudecken.

2. Kristallisationsvorrichtung (9) nach Anspruch 1, **dadurch gekennzeichnet, dass** die Zugabeeinrichtung eine Steuereinrichtung beinhaltet, die zum Zugeben von Bestandteilen, die aus der Gruppe beinhaltend Kristallisationsmittel, Additive und Puffer ausgewählt sind, zu der Lösung S2 in dem Reservoir (7) eingerichtet ist.

3. Kristallisationsvorrichtung (9) nach einem der vorhergehenden Ansprüche, **dadurch gekennzeichnet, dass** die Entnahmeeinrichtung eine Steuereinrichtung beinhaltet, die zum Entnehmen der gesamten oder eines Teils der Lösung S2 aus dem Reservoir eingerichtet ist.

4. Kristallisationsvorrichtung (9) nach einem der vorhergehenden Ansprüche, **dadurch gekennzeichnet, dass** die Zugabeeinrichtung und die Entnahmeeinrichtung eine peristaltische Mehrkanalpumpe beinhalten.

5. Kristallisationsvorrichtung (9) nach einem der vorhergehenden Ansprüche, **dadurch gekennzeichnet, dass** sie außerdem mindestens eine Einrichtung zur Kontrolle und Änderung der Temperatur der Kristallisationsvorrichtung (9) umfasst.

6. Kristallisationsvorrichtung (9) nach Anspruch 5, **dadurch gekennzeichnet, dass** die Einrichtung zur Kontrolle und Änderung der Temperatur eine Peltier-Zelle ist.

7. Kristallisationsvorrichtung (9) nach einem der vorhergehenden Ansprüche, **dadurch gekennzeichnet, dass** sie außerdem mindestens eine Einrichtung zur Messung der Konzentration des zu kristallisierenden Moleküls in der Lösung S1 umfasst.

8. Kristallisationsvorrichtung (9) nach einem der vorhergehenden Ansprüche, **dadurch gekennzeichnet, dass** die Kristallisationszelle (1) eine Oberkammer (12) umfasst, die derart eingerichtet ist, dass sie zwischen der Kristallisationskammer (2) und dem Reservoir (7) angebracht werden kann, und auf der die Dialysemembran angeordnet ist.

9. Kristallisationsvorrichtung (9) nach einem der vorhergehenden Ansprüche, **dadurch gekennzeichnet, dass** das Reservoir (7) einen Stopfen (6) umfasst, der mit einem optischen Fenster (14) ausgestattet ist und der an dem entgegengesetzten Ende zu der Dialysemembran angebracht ist.

10. Kristallisationsvorrichtung (9) nach einem der vorhergehenden Ansprüche, **dadurch gekennzeichnet, dass** die Dialysemembran eine Cellulosemembran oder eine synthetische Membran ist.

11. Kristallisationsvorrichtung (9) nach einem der vorhergehenden Ansprüche, **dadurch gekennzeichnet, dass** der optische Boden (4) aus Polycarbonat, Quarz oder Glas ist.

12. Kristallisationsverfahren für ein zu kristallisierendes Molekül, **dadurch gekennzeichnet, dass** das Verfahren die folgenden Schritte umfasst:
a) Bereitstellen:
- einer ersten Lösung S1 des besagten zu kristallisierenden Moleküls in der Kristallisationskammer (2) der Kristallisationszelle (1) einer Kristallisationsvorrichtung (9) nach einem der Ansprüche 1 bis 11, und dies mit einer ersten Temperatur T1 und mit einer Konzentration C1 des zu kristallisierenden Moleküls in der Lösung S1, so dass das zu kristallisierende Molekül sich in der spontanen Keimbildungszone oder an der oberen Grenze der metastabilen Zone des Diagramms der Phasen des besagten zu kristallisierenden Moleküls befindet, das in Abhängigkeit von Parametern der Konzentration des zu kristallisierenden Moleküls und der Temperatur erstellt wurde;
- einer zweiten Lösung S2, einer so genannten Kristallisationslösung, in dem Raum (8) der Kristallisationszelle (1), wobei die besagte Kristallisationslösung S2 mindestens ein Kristallisationsmittel und/oder ein Additiv mit einer konstanten Konzentration P enthält,
so dass das Kristallisationsmittel und/oder das Additiv in der Lösung S1 diffundieren und so dass Keime des zu kristallisierenden Moleküls erscheinen,
b) Erhöhen der Temperatur der Kristallisationszelle (1) auf eine Temperatur T2, so dass die Keimbildung gestoppt wird und dass das zu kristallisierende Molekül sich in der metastabilen Zone des Diagramms der Phasen des zu kristallisierenden Moleküls befindet,
c) Wachsenlassen der Kristallkeime bei der Temperatur T2 bis zum Erreichen eines ersten Gleichgewichtspunkts E1, bei dem die Kristallgröße konstant bleibt, wobei die erlangte Konzentration des zu kristallisierenden Moleküls in der Lösung S1 dann die Konzentration C2 ist,
d) Senken der Temperatur der Kristallisationskammer (2) auf eine Temperatur T3, so dass die in der Kristallisationskammer (2) vorhandenen Kristalle stets in der metastabilen Zone des Diagramms der Phasen des zu kristallisierenden Moleküls vorliegen,
e) Wachsenlassen der Kristallkeime und der Kristalle bei der Temperatur T3 bis zum Erreichen eines zweiten Gleichgewichtspunkts E2, bei dem die Kristallgröße konstant bleibt, wobei die erlangte Konzentration des zu kristallisierenden Moleküls in der Lösung S1 dann die Konzentration C3 ist,
f) Wiederholen der Schritte c) bis e) bis zum Erhalten von Kristallen mit der gewünschten Größe des zu kristallisierenden Moleküls,
g) Gewinnen der zum Abschluss des Schritts f) erhaltenen Kristalle.

13. Kristallisationsverfahren für ein zu kristallisierendes Molekül, **dadurch gekennzeichnet, dass** das Verfahren die folgenden Schritte umfasst:
a) Bereitstellen:
- einer ersten Lösung S1 des besagten zu kristallisierenden Moleküls in der Kristallisationskammer (2) der Kristallisationszelle (1) einer Kristallisationsvorrichtung (9) nach einem der Ansprüche 1 bis 11, und dies mit einer konstanten Temperatur T der Kristallisationszelle (1) und mit einer Konzentration C1 des zu kristallisierenden Moleküls in der Lösung S1, so dass das zu kristallisierende Molekül sich in der spontanen Keimbildungszone oder an der oberen Grenze der metastabilen Zone des Diagramms der Phasen des besagten zu kristallisierenden Moleküls befindet, das in Abhängigkeit von Parametern der Konzentration des zu kristallisierenden Moleküls und der Konzentration an Kristallisationsmittel und/oder Additiv erstellt wurde;
- einer zweiten Lösung S2, einer so genannten Kristallisationslösung, die mindestens ein Kristallisationsmittel und/oder ein Additiv mit der Konzentration P1 enthält, in dem Raum (8) der Kristallisationszelle (1),
so dass das Kristallisationsmittel und/oder das Additiv in der Lösung S1 diffundieren, so dass Keime des zu kristallisierenden Moleküls erscheinen,
b) Verringern der Konzentration des Kristallisationsmittels und/oder des Additivs auf eine Konzentration P2, so dass die Keimbildung gestoppt wird und dass das zu kristallisierende Molekül sich in der metastabilen Zone des Diagramms der Phasen des zu kristallisierenden Moleküls befindet,
c) Wachsenlassen der Kristallkeime bei der Konzentration P2 des Kristallisationsmittels und/oder des Additivs bis zum Erreichen eines ersten Gleichgewichtspunkts E1, bei dem die Kristallgröße konstant bleibt, wobei die erlangte Konzentration des zu kristallisierenden Moleküls in der Lösung S1 dann die Konzentration C2 ist,
d) Erhöhen der Konzentration des Kristallisationsmittels und/oder des Additivs auf eine Konzentration P3, so dass die in der Kristallisationskammer (2) vorhandenen Kristalle stets in der metastabilen Zone des Diagramms der Phasen des zu kristallisierenden Moleküls vorliegen,
e) Wachsenlassen der Kristallkeime und der Kristalle bei der Konzentration P3 des Kristallisationsmittels und/oder des Additivs bis zum Erreichen eines zweiten Gleichgewichtspunkts E2, bei dem die Kristallgröße konstant bleibt, wobei die erlangte Konzentration des zu kristallisierenden Moleküls in der Lösung S1 die Konzentration C3 ist,
f) Wiederholen der Schritte c) bis e) bis zum Erhalten von Kristallen mit der gewünschten Größe des zu kristallisierenden Moleküls,
g) Gewinnen der zum Abschluss des Schritts f) erhaltenen Kristalle.

## Claims

1. A device (9) for crystallizing a molecule to be crystallized which comprises:
- at least one crystallization cell (1), the crystallization cell (1) comprising:
• a crystallization chamber (2), in which is arranged a cavity (3) intended to receive a first solution S1 containing the molecule to be crystallized and its crystal seeds, and optionally at least one buffer, the cavity (3) including an optical base (4) and an opening (5),
• a dialysis membrane,
• a tank (7) intended to be fitted onto the crystallization chamber (2), so as to create a watertight compartment formed on the one hand by the tank (7) and on the other hand by the crystallization chamber (2), the compartment being intended to be filled with a second solution S2, called crystallization solution which contains components selected from the group composed of the crystallization agents, the additives and the buffers,
- at least one image acquisition means,
- at least one addition means arranged to add in the tank (7) components selected from the group composed of the crystallization agents, the additives and the buffers to the solution S2 and/or
- at least one sampling means arranged to sample in the tank (7) all or part of the solution S2,
said crystallization device (9) is **characterized in that** the opening (5) faces the optical base (4) and **in that** the dialysis membrane is intended to cover the opening (5) of the cavity (3) of the crystallization chamber (2).

2. The crystallization device (9) according to claim 1, **characterized in that** the addition means consists of a drive means arranged to add in the tank (7) components selected from the group composed of the crystallization agents, the additives and the buffers to the solution S2.

3. The crystallization device (9) according to any one of the preceding claims, **characterized in that** the sampling means consists of a drive means which is arranged to sample in the tank all or part of the solution S2.

4. The crystallization device (9) according to any one of the preceding claims, **characterized in that** the addition means and the sampling means consist of a multichannel peristaltic pump.

5. The crystallization device (9) according to any one of the preceding claims, **characterized in that** it further comprises at least one means for controlling and varying the temperature of the crystallization device (9).

6. The crystallization device (9) according to claim 5, **characterized in that** the means for controlling and varying temperature is a Peltier Effect Cell.

7. The crystallization device (9) according to any one of the preceding claims, **characterized in that** it further comprises at least one means for measuring the concentration of the molecule to be crystallized in the solution S1.

8. The crystallization device (9) according to any one of the preceding claims, **characterized in that** the crystallization cell (1) comprises an overchamber (12) arranged so as to be fastened between the crystallization chamber (2) and the tank (7) and on which the dialysis membrane is disposed.

9. The crystallization device (9) according to any one of the preceding claims, **characterized in that** the tank (7) comprises a plug (6), equipped with an optical window (14), which is fastened to the end opposite to the dialysis membrane.

10. The crystallization device (9) according to any one of the preceding claims, **characterized in that** the dialysis membrane is a membrane made of cellulose or a synthetic membrane.

11. The crystallization device (9) according to any one of the preceding claims, **characterized in that** the optical base (4) is made of polycarbonate, quartz or glass.

12. A method for crystallizing a molecule to be crystallized **characterized in that** it comprises the following steps:
a) providing:
- a first solution S1 of said molecule to be crystallized in the crystallization chamber (2) of the crystallization cell (1) of a crystallization device (9) according to any one of claims 1 to 11, and this at a first temperature T1 and a concentration C1 of the molecule to be crystallized in the solution S1, so that the molecule to be crystallized is located in the spontaneous nucleation area or on the upper limit of the metastable area of the phase diagram of said molecule to be crystallized established depending on the concentration parameters of the molecule to be crystallized and on the temperature;
- a second solution S2, called crystallization solution, in the compartment (8) of the crystallization cell (1), said crystallization solution S2 containing at least one crystallization agent and/or one additive at a constant concentration P,
so that the crystallization agent and/or the additive diffuse(s) into the solution S1 and so that seeds of the molecule to be crystallized appear.
b) increasing the temperature of the crystallization cell (1) to a temperature T2 so that nucleation is stopped and that the molecule to be crystallized is located in the metastable area of the phase diagram of the molecule to be crystallized.
c) allowing the crystal seeds to grow at the temperature T2 until obtaining a first balance point E1, where the size of the crystals remains constant, the reached concentration of the molecule to be crystallized in the solution S1 then being the concentration C2.
d) decreasing the temperature of the crystallization chamber (2) to a temperature T3, so that the crystals present in the crystallization chamber (2) are always located in the metastable area of the phase diagram of the molecule to be crystallized.
e) allowing the crystal seeds and the crystals to grow at the temperature T3 until obtaining a second balance point E2 where the size of the crystals remains constant, the reached concentration of the molecule to be crystallized in the solution S1 being then the concentration C3.
f) repeating steps c) to e) until obtaining crystals of the desired size of the molecule to be crystallized.
g) recovering the crystals at the end of step f).

13. The method for crystallizing a molecule to be crystallized, **characterized in that** it comprises the following steps:
a) providing:
- a first solution S1 of said molecule to be crystallized in the crystallization chamber (2) of the crystallization cell (1) of a crystallization device (9) according to any one of claims 1 to 11, and this at a constant temperature T of the crystallization cell (1) and at a concentration C1, so that the molecule to be crystallized is located in the spontaneous nucleation area or on the upper limit of the metastable area of the phase diagram of said molecule to be crystallized established depending on the concentration parameters of the molecule to be crystallized and on the crystallization agent and/or additive concentration;
- a second solution S2, called crystallization solution, containing at least one crystallization agent and/or one additive at the concentration P1 in the compartment (8) of the crystallization cell (1),
so that the crystallization agent and/or the additive diffuse(s) into the solution S1, so that seeds of the molecule to be crystallized appear.
b) decreasing the concentration of the crystallization agent and/or the additive to a concentration P2, so that the nucleation is stopped and that the molecule crystallize is located in the metastable area of said phase diagram of the molecule to be crystallized.
c) allowing the crystal seeds to grow at the concentration P2 of the crystallization agent and/or the additive until obtaining a first balance point E1, where the size of the crystals remains constant, the reached concentration of the molecule to be crystallized in the solution S1 being then the concentration C2.
d) increasing the concentration of the crystallization agent and/or the additive to a concentration P3, so that the crystals present in the crystallization chamber (2) are always located in the metastable area of said phase diagram of the molecule to be crystallized,
e) allowing the crystal seeds and the crystals to grow at the concentration P3 of the crystallization agent and/or the additive until obtaining a second balance point E2 where the size of the crystals remains constant, the reached concentration of the molecule to be crystallized in the solution S1 is concentration C3,
f) repeating steps c) to e) until obtaining crystals of the desired size of the molecule to be crystallized.
g) recovering the crystals obtained from step f).
